# EUROPEAN PATENT SPECIFICATION

(11) **EP 4 375 678 B1**
(45) Date of publication and mention of the grant of the patent: **24.12.2025**
(21) Application number: 22210045.5
(22) Date of filing: 28.11.2022
(51) Int. Cl.: G01R 15/20

(54) **INTEGRATED CIRCUIT CURRENT TRANSDUCER**
STROMWANDLER MIT INTEGRIERTER SCHALTUNG
TRANSDUCTEUR DE COURANT À CIRCUIT INTÉGRÉ

(43) Date of publication of application: 29.05.2024
(73) Proprietor: LEM International SA, 1217 Meyrin (CH)
(72) Inventor: ZIGLIOLI, Federico Giovanni, 1207 Genève (CH)
(74) Representative: reuteler & cie SA

(56) References cited:
- EP-A1- 3 943 952
- DE-A1- 102011 107 703
- US-A1- 2014 239 426
- US-B2- 8 680 843

## Description

The present invention relates to an open-loop integrated circuit current transducer for surface mounting on a circuit board.

It is known to provide open-loop current transducers having surface mount electrical connections for mounting on a circuit board. In many applications, there is an advantage in having a very compact and low height current transducer having an integrated primary conductor within an overmolded insulative housing. Such coreless current transducers may include an integrated circuit (IC) chip having an active sensing layer thereon detecting the magnetic field induced by a current to be measured flowing in a primary conductor integrated within the current transducer, the integrated circuit chip being electrically connected to secondary contacts that supply power and allow transmission of the measurement signal to the external circuit board.

It is well known to form the primary and secondary conductors from a lead frame. A lead frame is a strip of sheet metal that is stamped and formed to cut out primary and secondary contacts from the sheet metal, the contacts and integrated circuit being overmolded by an insulating polymer, connection ends of the contacts being exposed and configured for a solder or welding connection to circuit traces on the circuit board.

The electrical interconnection between the integrated circuit and the secondary contacts may be connected by a so-called "flip-chip" connection or by wire bonding. Active portions and connection interfaces on the semi-conductor substrate which, for instance a CMOS IC, are typically provided on a same single side of the IC. A flip-chip arrangement, for instance as described in US 2006/219436 A1, allows the active side to be facing and adjacent the lead frame conductor arrangement, allowing electrical interconnection between the lead frame and connection portions on the integrated circuit active surface, while at the same time having the active sensing portion of the integrated circuit being very close to the primary conductor. This provides greater sensitivity for measurement of the primary current due to the very small distance between the sensing layer and the primary conductor. Flip-chip connections can however be costly and complex to manufacture because of the small distances on the IC chip between connection points that need to be directly connected to the secondary conductors of the lead frame arrangement. There may also be disadvantages regarding electrical creepage distances that are more difficult to manage than in wire bond interconnections.

Wire bonding is a very common and widely used technique for interconnecting integrated circuits to conductors forming connection terminals for the IC chip. In conventional current transducers with wire bonding between the lead frame and IC chip, for instance as described in US 2016/ 282388 A1, the active sensor side faces away from the lead frame conductor arrangement in order to have the active surface accessible for the wire bonding between the lead frame terminals and the connection points on the IC circuit. There is thus a lower sensitivity compared to a flip-chip arrangement. Also, the position of the primary and secondary conductors limits the possibilities for shielding of the magnetic field sensor on the IC chip.

Further relevant prior art is disclosed in US 2014/239426 A1.

In view of the foregoing, it is an object of the present invention is to overcome the drawbacks of both conventional flip-chip and conventional wire bonded arrangements in open-loop current transducers for surface mount on circuit boards. In particular, it is an object of the invention to provide an open-loop current transducer for surface mounting on a circuit board that has a high measurement sensitivity, yet that is economical to manufacture.

It is advantageous to provide an open-loop surface mount current transducer that has electrical shielding in an economical and compact configuration,

Objects of the invention have been achieved by providing an open loop current transducer according to claim 1.

Disclosed herein is an open-loop electrical current transducer for surface mounting on an external circuit board, comprising
- an integrated circuit (IC) chip comprising an active first side, a second side, a magnetic field sensing portion on the active side and connection terminals on the active side,
- a primary conductor for carrying a current to be measured,
- a lead frame arrangement comprising a plurality of secondary conductors,
- a plurality of bond wires interconnecting the secondary conductors to the connection terminals of the IC chip, and
- an insulating housing overmolded over the IC chip, the bond wires, and a portion of the lead frame arrangement.

The primary conductor comprises
- at least one pair of lead frame primary conductor terminals which form part of the lead frame arrangement, the lead frame primary conductor terminals being separated from each other by an insulating gap,
- a separately formed primary conductor plate mounted on top of the active side of the IC chip, separated from the active side by an insulating layer, the primary conductor plate overlying the magnetic field sensing portion, and
- a plurality of bond wires interconnecting each of the lead frame primary conductor terminals to respective end portions of the primary conductor plate.

In an advantageous embodiment, there are a plurality of primary bond wires interconnecting each of the lead frame primary conductor terminals to respective connection end portions of the primary conductor plate.

In an advantageous embodiment, there are three or more primary bond wires interconnecting each of the lead frame primary conductor terminals to respective connection end portions of the primary conductor plate.

In an advantageous embodiment, the primary conductor plate is a stamped out sheet metal part.

In an advantageous embodiment, the primary conductor plate comprises connection end portions and a centre portion between the connection end portions having a reduced conductive cross-sectional area compared to connection end portions.

In an advantageous embodiment, the centre portion is positioned directly overhead the magnetic field sensing portion on the active side of the IC chip.

In an advantageous embodiment, the insulating sheet has a surface area and periphery extending beyond a surface area and periphery of the primary conductor plate.

In an advantageous embodiment, the insulating sheet comprises a polyimide material layer.

According to the invention, the plurality of secondary conductors includes a grounded shielding conductor positioned below and having a portion overlapping the IC chip.

According to the invention, the grounded shielding conductor has a U shape with a centre branch forming the portion overlapping the IC chip and lateral branches forming outermost conductors of the secondary conductors.

Further objects and advantageous features of the invention will be apparent from the claims, from the detailed description, and annexed drawings, in which:

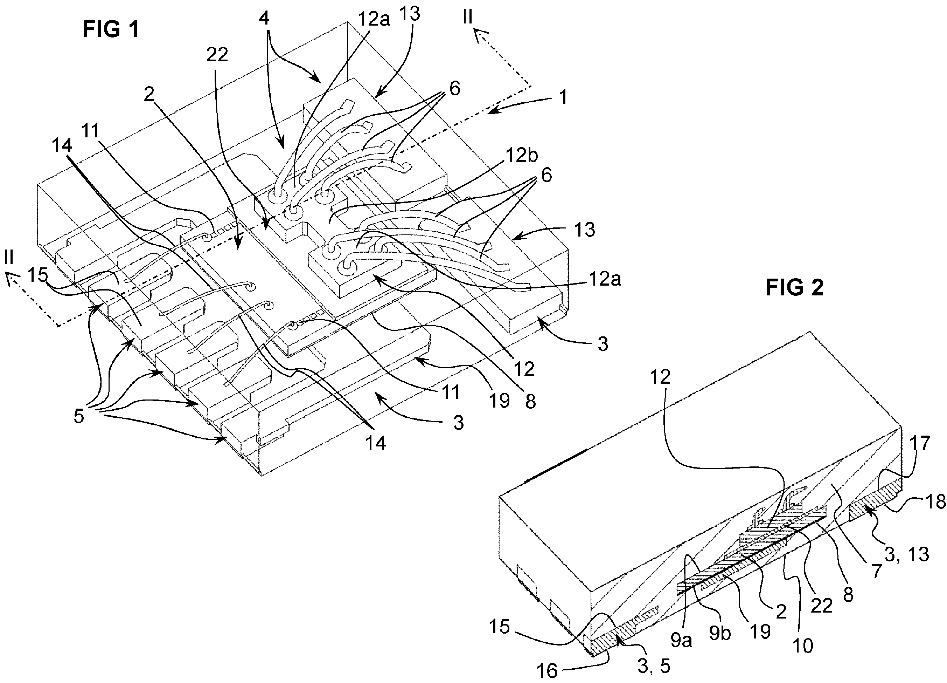

Figure 1 is a perspective view of a surface mount open-loop current transducer according to an embodiment of the invention, the overmold housing portion being shown transparent;
Figure 2 is a cross-sectional view through line II-II of figure 1.

Referring to the figures, an electric current transducer 1 for surface mount connection on an external circuit board comprises a magnetic field sensor 2 mounted on a lead frame arrangement 3 housed within an insulating overmold housing 7.

The magnetic field sensor 2 is in the form of an integrated circuit (IC) chip having a first active side 9a and a second side 9b, at least the first active side 9a having active portions including electrical connection terminals 11 for connection to power and signal transmission conductors and a magnetic field sensor portion arranged at or close to the surface of the first side.

An insulating layer 8 is positioned between the second side 9b of the IC chip and the lead frame 3. The insulating layer 8 may consist of an adhesive material to bond to the second side surface of the IC chip and a surface portion of the lead frame which is covered by the insulating layer during the assembly process of the transducer, or may comprise an insulating foil of material bonded to the lead frame and/or IC chip with an adhesive coating. The insulating layer may also be welded to the lead frame or held in an assembled position between the lead frame and the IC chip by other means prior to the overmolding of the insulating housing 7.

The magnetic field sensing portion may comprise a Hall effect sensor, or a giant magnetoresistive sensor or other forms of magnetic field sensors that are *per se* well known in the art. The IC chip 2 may for instance be in the form of a CMOS chip although other types of semi-conductor integrated circuit chips with magnetic field sensing portions *per se* known in the art may be used. The semi-conductor chip does not need to be further described, such semi-conductor chips with magnetic field sensing portions and connection terminals being *per se* well known in the art.

The lead frame arrangement 3 comprises a primary conductor 4 and a plurality of secondary conductors 5. The lead frame arrangement is formed from a sheet of conductive metal, more specifically in the form of a band or strip that is stamped and formed in a stamping and forming process to cut out, bend and/or emboss the sheet metal to form the primary and secondary conductors. Stamping and forming of lead frame arrangements from sheet metal are *per se* well known techniques.

The primary conductor comprises a pair of primary conductor terminals 13 configured for connection to conductive traces on an external circuit board, a primary conductor plate 12 overlying the active side 9a of the IC chip 2, and primary conductor bond wires 6 interconnecting the pair of surface mount connection terminals 13 to the primary conductor plate.

An insulating sheet 22 is positioned between the active side 9a of the IC chip and the primary conductor plate 12. The thickness of the insulating sheet 22 defines the gaps between the primary conductor and the magnetic field sensing portion on the active side 9a of the IC chip. The insulating sheet 22 comprises an insulating foil of material that may be bonded to the primary conductor plate and/or IC chip with an adhesive coating. The insulating sheet may also be welded to the primary conductor plate or held in an assembled position between the lead frame and the IC chip by other means prior to the overmolding of the insulating housing 7. The insulating sheet 22 preferably has a surface area and outer contour that extends beyond the periphery of the primary conductor plate 12 in order to increase an electrical path length between the primary conductor plate 12 and the IC chip 2. In an advantageous embodiment, insulating layer material comprises or consists of a polyimide material layer which has a high electrical breakdown resistance, excellent electrical insulation properties and can be manufactured with high accuracy in its thickness. Other insulating materials such as ceramics or glass may also be used.

The primary conductor terminals 13 have exposed contact surfaces 18 on a mounting side 10 of the IC chip configured for surface mount connection to conductive traces on an external circuit board. The other side of the primary conductor terminals 13 forms a wire bonding surface 17. In variants, the primary conductor terminals may have stamped and formed contact portions with various shapes and configurations, for instance that project below and outwardly from the IC chip housing lower surface 10, adapted for surface mount connection to circuit board conductive traces as *per se* known in the art.

The primary conductor plate 12 comprises connection end portions 12a and a centre portion 12b between the connection end portions 12a having a reduced conductive cross-sectional area compared to connection end portions. The reduced cross-sectional area serves to concentrate the current to be measured (the primary current) and increase the intensity of the magnetic field around the centre portion 12a of the primary conductor plate 12. The centre portion 12b may advantageously be positioned directly overhead the magnetic field sensing portion on the active side 9a of the IC chip.

The primary conductor plate 12 may advantageously be formed out of sheet metal in a stamping process similar to the process used to produce the lead frame. The primary conductor plate 12 may in variants be stamped out of the lead frame 3, as a separate part that is removed from the lead frame and assembled on top of the IC chip 2 and insulating sheet 22. The material for the primary conductor plate 12 may for instance be stamped out of the lead frame between the secondary conductors 5 and the primary conductor terminals 13, thus in the material forming a gap between the secondary conductors 5 and the primary conductor terminals 13. The primary conductor plate12 may for instance have a thickness in the range from 50 to 300um.

In variants, the primary conductor plate 12 may be formed out of different conductive materials by other *per se* known forming methods such as additive (3D printing) manufacturing techniques, casting or injection, forging, or machining.

The separately formed primary conductor plate 12 assembled on top of the IC chip active side 9a is electrically connected to the primary conductor terminals 13 with the primary conductor bond wires 6 that are welded to the primary conductor plate 12 and to the bonding side 17 of the primary conductor terminals 13 with *per se* well known techniques employed for connection of bond wires to metallic conductor surfaces.

The well known bonding wire connection technique allows to employ cost efficient manufacturing processes for interconnecting the primary conductor plate to the primary conductor terminals, and cost efficient manufacturing process to form the secondary conductors and primary conductor terminals out of a lead frame, while ensuring positioning of the primary conductor in very close proximity to the magnetic field sensing portion of the IC chip, in an overall compact transducer arrangement.

In order to ensure that a high primary current may flow between the primary conductor terminals 13 and the primary conductor plate 12, a plurality of bond wires 6 are connected between the connection end portions 12a of the primary conductor plate 12 and the respective primary conductor terminals 13. This allows to use standard wire bond connection techniques yet have sufficient current carrying capacity for the primary conductor 4 by simply increasing the number of bond wires 6. The number of wires can be changed based on the bond wire diameter and the intended current carrying capability of the transducer. For the bond wires 6, as an example,1.5-2 mils copper wire can be used for instance.

The secondary conductors 5 which serve to interconnect the IC chip 2 to power and signal connections of an external circuit to which the current transducer is intended to be connected, comprise a plurality of conductors formed from the lead frame arrangement as previously discussed, each secondary conductor comprising a connection portion 15 on one side and a surface mount connection terminal 16 on the other side. The surface mount connection terminal 16 may be for instance arranged in a row presenting contact pads intended for surface mount solder or welding connection, as *per se* known in the art, to circuit traces of an external circuit board. The surface mount connection terminals 16 are thus positioned proximate an outer edge of the transducer overmold housing 7, the IC connection side 15 being positioned proximate the IC chip 2 allowing bond wire connections between the IC chip 2 and the IC connection side 15 of the secondary conductors. In variants, the secondary conductor terminals may have stamped and formed contact portions with various shapes and configurations, for instance that project below and outwardly from the IC chip housing lower surface 10, adapted for surface mount connection to circuit board conductive traces as *per se* known in the art.

Bond wires 14 are connected between the IC connection side 15 of each secondary conductor 5 and connection terminals 11 on the active first side 9a of the IC chip 2. It may be noted that certain secondary conductors may have no connection to the IC chip, forming a redundant secondary conductor for use with semi-conductor chips with more connection portions. In other words, the number of connections depend on the functions incorporated in the IC chip. The lead frame conductor arrangement 3 may have a constant configuration, whereas the number of wire bond interconnections between the secondary conductors and IC chip may depend on the configuration of the IC chip and desired functionalities to be incorporated in the transducer.

The lead frame may be plated with any suitable wire bondable layer in accordance with the bond wires used for the primary and secondary conductors.

The plurality of secondary conductors may advantageously include a grounded conductor 19 positioned below and overlapping the IC chip 2, whereby the IC chip is mounted on the grounded conductor 19 separated therefrom by the insulating layer 8. The grounded conductor 19 advantageously has a general U shape with a centre branch forming the portion overlapping the IC chip and lateral branches forming outermost conductors of the secondary conductors 5.The grounded conductor 19 may serve either as a shielding conductor for electrical shielding of the IC chip 2, or serve as a heat conductor to evacuate heat from the IC chip 2, or both as an electrical shielding conductor and heat transfer conductor.

### List of references used

electric current transducer 1
**magnetic field sensor 2 (integrated circuit (IC) chip)**
   **first side (active side) 9a**
      magnetic field sensing portion
      connection terminals 11
   **second side 9b**
**insulating sheet 22 (between IC chip and primary conductor plate)**
**insulating layer 8 (between IC chip and lead frame)**
**primary conductor 4**
   primary conductor plate 12
      connection end portions 12a
      centre portion 12b
   primary conductor terminals 13
      bonding surface 17
      contact surface 18
   primary conductor bond wires 6
**lead frame arrangement 3**
   *Primary conductor terminals 13*
   *secondary conductors 5*
      *shield conductor 19*
**secondary conductors 5**
   IC connection side 15
   surface mount connection terminals 16
   shield conductor 19
   secondary conductor bond wires 14
Overmold housing 7
   mounting side 10

## Claims

1. An open-loop electrical current transducer (1) for surface mounting on an external circuit board, comprising
- an integrated circuit (IC) chip (2) comprising an active first side (9a), a second side (9b), a magnetic field sensing portion on the active side, and connection terminals (11) on the active side,
- a primary conductor (4) for carrying a current to be measured,
- a lead frame arrangement (3) comprising a plurality of secondary conductors (5),
- a plurality of secondary conductor bond wires (14) interconnecting two or more of the secondary conductors (5) to the connection terminals (11) of the IC chip, and
- an insulating housing (7) overmolded over the IC chip, the secondary conductor bond wires, and a portion of the lead frame arrangement (3),
the primary conductor (4) comprising
- at least one pair of primary conductor terminals (13) which form part of the lead frame arrangement, the lead frame primary conductor terminals being separated from each other by an insulating gap,
- a separately formed primary conductor plate (12) mounted on top of the active side (9a) of the IC chip (2), separated from the active side by an insulating sheet (22), the primary conductor plate overlying the magnetic field sensing portion, and
- at least one primary bond wire (6) interconnecting each of the lead frame primary conductor terminals (13) to respective connection end portions (12a) of the primary conductor plate,
**characterised in that**
the plurality of secondary conductors (5) includes a grounded shielding conductor (19) positioned below and having a portion overlapping the IC chip (2), and wherein the grounded shielding conductor (19) has a U shape with a centre branch forming the portion overlapping the IC chip and lateral branches forming outermost conductors of the secondary conductors (5).

2. Current transducer according to the preceding claim wherein there are a plurality of primary bond wires (6) interconnecting each of the lead frame primary conductor terminals (13) to respective connection end portions (12a) of the primary conductor plate.

3. Current transducer according to the preceding claim wherein there are three or more primary bond wires (6) interconnecting each of the lead frame primary conductor terminals (13) to respective connection end portions (12a) of the primary conductor plate.

4. Current transducer according to any preceding claim wherein the primary conductor plate (12) is a stamped out sheet metal part.

5. Current transducer according to any preceding claim wherein the primary conductor plate (12) comprises connection end portions (12a) and a centre portion (12b) between the connection end portions (12a) having a reduced conductive cross-sectional area compared to connection end portions.

6. Current transducer according to the preceding claim wherein the centre portion (12b) is positioned directly overhead the magnetic field sensing portion on the active side (9a) of the IC chip.

7. Current transducer according to any preceding claim wherein the insulating sheet (22) has a surface area and periphery extending beyond a surface area and periphery of the primary conductor plate (12).

8. Current transducer according to any preceding claim wherein the insulating sheet (22) comprises a polyimide material layer.

## Patentansprüche

1. Elektrischer Stromwandler (1) mit offenem Regelkreis zur Oberflächenmontage an einer externen Leiterplatte, umfassend:
- einen integrierten Schaltungs-(IC)-Chip (2), der eine erste, aktive Seite (9a), eine zweite Seite (9b), einen Magnetfeldmessungsabschnitt auf der aktiven Seite und Verbindungsanschlüsse (11) auf der aktiven Seite umfasst,
- einen Primärleiter (4) zum Tragen eines zu messenden Stroms,
- eine Leiterrahmenanordnung (3), die eine Vielzahl von Sekundärleitern (5) umfasst,
- eine Vielzahl von Sekundärleiter-Bonddrähten (14), die zwei oder mehr der Sekundärleiter (5) mit den Verbindungsanschlüssen (11) des IC-Chips zusammenschalten, und
- ein Isolationsgehäuse (7), das über dem IC-Chip, den Sekundärleiter-Bonddrähten und einem Abschnitt der Leiterrahmenanordnung (3) übergeformt ist,
wobei der Primärleiter (4) umfasst
- mindestens ein Paar Primärleiteranschlüsse (13), die einen Teil der Leiterrahmenanordnung bilden, wobei die Leiterrahmen-Primärleiteranschlüsse durch einen Isolationsspalt voneinander getrennt sind,
- eine getrennt gebildete Primärleiterplatte (12), die auf einem Oberteil der aktiven Seite (9a) des IC-Chips (2) montiert ist und von der aktiven Seite durch eine Isolierlage (22) getrennt ist, wobei die Primärleiterplatte über dem Magnetfeldmessungsabschnitt liegt, und
- mindestens einen Primärbonddraht (6), der jeden von den Leiterrahmen-Primärleiteranschlüssen (13) mit entsprechenden Verbindungsendabschnitten (12a) der Primärleiterplatte zusammenschaltet,
**dadurch gekennzeichnet, dass**
die Vielzahl von Sekundärleitern (5) einen geerdeten Abschirmungsleiter (19) umfassen, der unter dem IC-Chip (2) positioniert ist und einen Abschnitt aufweist, der diesen überlappt, und wobei der geerdete Abschirmungsleiter (19) eine U-Form mit einem mittleren Zweig, der den Abschnitt bildet, der den IC-Chip überlappt, und seitlichen Zweigen umfasst, die äußerste Leiter der Sekundärleiter (5) bilden.

2. Stromwandler nach dem vorhergehenden Anspruch, wobei eine Vielzahl von Primärbonddrähten (6) vorhanden sind, die jeden der Leiterrahmen-Primärleiteranschlüsse (13) mit entsprechenden Verbindungsendabschnitten (12a) der Primärleiterplatte verbinden.

3. Stromwandler nach dem vorhergehenden Anspruch, wobei drei oder mehr Primärbonddrähte (6) vorhanden sind, die jeden der Leiterrahmen-Primärleiteranschlüsse (13) mit entsprechenden Verbindungsendabschnitten (12a) der Primärleiterplatte zusammenschalten.

4. Stromwandler nach einem der vorhergehenden Ansprüche, wobei die Primärleiterplatte (12) ein ausgestanztes Blechteil ist.

5. Stromwandler nach einem der vorhergehenden Ansprüche, wobei die Primärleiterplatte (12) Verbindungsendabschnitte (12a) und einen mittleren Abschnitt (12b) zwischen den Verbindungsendabschnitten (12a) umfasst, die im Vergleich zu Verbindungsendabschnitten eine verminderte leitfähige Querschnittsfläche aufweisen.

6. Stromwandler nach dem vorhergehenden Anspruch, wobei der mittlere Abschnitt (12b) direkt über dem Magnetfeldmessungsabschnitt auf der aktiven Seite (9a) des IC-Chips positioniert ist.

7. Stromwandler nach einem der vorhergehenden Ansprüche, wobei die Isolierlage (22) einen Flächeninhalt und Umfang aufweist, der sich über einen Flächeninhalt und Umfang der Primärleiterplatte (12) hinaus erstreckt.

8. Stromwandler nach einem der vorhergehenden Ansprüche, wobei die Isolierlage (22) eine Polyimid-Materialschicht umfasst.

## Revendications

1. Transducteur de courant électrique (1) en boucle ouverte pour un montage en surface sur une carte de circuit externe, comprenant
- une puce à circuit intégré (CI) (2) comprenant un premier côté actif (9a), un deuxième côté (9b), une partie de détection de champ magnétique sur le côté actif, et des bornes de connexion (11) sur le côté actif,
- un conducteur primaire (4) pour le transport d'un courant à mesurer,
- un agencement de grille de connexion (3) comprenant une pluralité de conducteurs secondaires (5),
- une pluralité de fils de câblage de conducteur secondaire (14) interconnectant deux des conducteurs secondaires (5) ou plus aux bornes de connexion (11) de la puce à CI, et
- un boîtier isolant (7) surmoulé sur la puce à CI, les fils de câblage de conducteur secondaire, et une partie de l'agencement de grille de connexion (3),
le conducteur primaire (4) comprenant
- au moins une paire de bornes de conducteur primaire (13) qui font partie de l'agencement de grille de connexion, les bornes de conducteur primaire de grille de connexion étant séparées les unes des autres par un espace isolant,
- une plaque de conducteur primaire (12) formée séparément montée sur le dessus du côté actif (9a) de la puce à CI (2), séparée du côté actif par une feuille isolante (22), la plaque de conducteur primaire recouvrant la partie de détection de champ magnétique, et
- au moins un fil de câblage primaire (6) interconnectant chacune des bornes de conducteur primaire de grille de connexion (13) à des parties d'extrémité de connexion (12a) respectives de la plaque de conducteur primaire,
**caractérisé en ce que**
la pluralité de conducteurs secondaires (5) inclut un conducteur de blindage mis à la masse (19) positionné au-dessous de la puce à CI (2) et ayant une partie chevauchant celle-ci, et dans lequel le conducteur de blindage mis à la masse (19) possède une forme en U dotée d'une branche centrale formant la partie chevauchant la puce à CI et de branches latérales formant des conducteurs les plus externes des conducteurs secondaires (5).

2. Transducteur de courant selon la revendication précédente dans lequel il y a une pluralité de fils de câblage primaires (6) interconnectant chacune des bornes de conducteur primaire de grille de connexion (13) à des parties d'extrémité de connexion (12a) respectives de la plaque de conducteur primaire.

3. Transducteur de courant selon la revendication précédente dans lequel il y a trois fils de câblage primaires (6) ou plus interconnectant chacune des bornes de conducteur primaire de grille de connexion (13) à des parties d'extrémité de connexion (12a) respectives de la plaque de conducteur primaire.

4. Transducteur de courant selon une quelconque revendication précédente dans lequel la plaque de conducteur primaire (12) est une pièce de tôle métallique découpée par emboutissage.

5. Transducteur de courant selon une quelconque revendication précédente dans lequel la plaque de conducteur primaire (12) comprend des parties d'extrémité de connexion (12a) et une partie centrale (12b) entre les parties d'extrémité de connexion (12a) ayant une aire de section transversale conductrice réduite comparativement aux parties d'extrémité de connexion.

6. Transducteur de courant selon la revendication précédente dans lequel la partie centrale (12b) est positionnée directement au-dessus de la partie de détection de champ magnétique sur le côté actif (9a) de la puce à CI.

7. Transducteur de courant selon une quelconque revendication précédente dans lequel la feuille isolante (22) possède une aire de surface et une périphérie s'étendant au-delà d'une aire de surface et d'une périphérie de la plaque de conducteur primaire (12).

8. Transducteur de courant selon une quelconque revendication précédente dans lequel la feuille isolante (22) comprend une couche de matériau polyimide.
